# EUROPEAN PATENT SPECIFICATION

(11) **EP 3 675 192 B1**
(45) Date of publication and mention of the grant of the patent: **24.07.2024**
(21) Application number: 18800466.7
(22) Date of filing: 17.05.2018
(51) Int. Cl.: G01B 7/16, G01B 17/04, H10K 71/00, H10K 77/10, H10K 102/00

(54) **FLEXIBLE SUBSTRATE AND PREPARATION METHOD THEREFOR, METHOD FOR DETECTING BENDING, AND FLEXIBLE DISPLAY DEVICE**
FLEXIBLES SUBSTRAT UND HERSTELLUNGSVERFAHREN DAFÜR, VERFAHREN ZUM ERFASSEN EINER BIEGUNG UND FLEXIBLE ANZEIGEVORRICHTUNG
SUBSTRAT SOUPLE ET SON PROCÉDÉ DE PRÉPARATION, PROCÉDÉ DE DÉTECTION DE FLEXION ET DISPOSITIF D'AFFICHAGE SOUPLE

(30) Priority: 23.08.2017 CN 201710740020
(43) Date of publication of application: 01.07.2020
(73) Proprietor: BOE TECHNOLOGY GROUP CO., LTD., Beijing 100015 (CN)
(72) Inventor: LIANG, Zhiwei, Beijing 100176 (CN); LIU, Yingwei, Beijing 100176 (CN)
(74) Representative: Jacobacci Coralis Harle
(86) International application number: PCT/CN2018/087262
(87) International publication number: WO 2019/037485

(56) References cited:
- CN-A- 102 081 894
- CN-A- 102 420 582
- CN-A- 102 435 959
- JP-B2- 5 717 247
- US-A- 3 978 731
- US-A- 4 107 626
- US-A1- 2006 289 901
- US-A1- 2015 207 102
- LI, TONGZE: "New Type of Transducer-Saw Displacement and Saw Accelerometers", AERODYNAMIC EXPERIMENT AND MEASUREMENT & CONTROL, vol. 3, no. 3, 30 September 1989 (1989-09-30), pages 59 - 68, XP009515801, ISSN: 1001-1641
- ZHOU, JIAN ET AL.: "Flexible ZnO Thin Film Saw Device on Polyimide Substrate", OPTICS AND PRECISION ENGINEERING, vol. 22, no. 2, 28 February 2014 (2014-02-28), pages 346 - 350, XP055614984

## Description

### CROSS-REFERENCE TO RELATED APPLICATION

This application claims the benefit and priority of Chinese Patent Application No. 201710740020.6 filed on August 23, 2017.

### FIELD

Embodiments of the present disclosure relate to a flexible substrate and a fabrication method thereof, a method for detecting bend, and a flexible display device.

### BACKGROUND

Flexible display technologies have been developed rapidly in recent years which has led to great progress in flexible display from screen size to display quality of flexible display. Also referred to as rollable display, the flexible display has many advantages compared with conventional hard-screen display such as impact resistance, strong in shock resistance, light in weight, small in size, convenient to carry, and low in cost. In that field, document US 4107626A describes a sensors for converting mechanical strain to an electronic digital signal utilizing surface acoustic wave oscillators; document US 3978731A describes a transducer which uses surface acoustic waves as a means of detecting pressure, acceleration, temperature, stress or strain in a digital manner; document US 2006/289901A1 describes a monolithic electronic device including a first nitride epitaxial structure including a plurality of nitride epitaxial layers; document US 2015/207102A1 describes a foldable, flexible display apparatus including a flexible display panel which display an image and includes a display side on which the image is displayed and of which portions thereof face each other in a folded state of the flexible display apparatus.

### SUMMARY

The present invention is set out in the appended set of claims.

Embodiments of the present disclosure disclose a flexible substrate and a fabrication method thereof, a method for detecting a bend, and a flexible display device.

At a first aspect of the present disclosure, there is provided a flexible substrate according to claim 1, comprising, inter alia, a flexible base, and a surface acoustic wave generating element and a surface acoustic wave detecting element positioned on the flexible base. The surface acoustic wave generating element and the surface acoustic wave detecting element are configured to detect a bend of the flexible substrate.

In one or more embodiments of the present disclosure, the surface acoustic wave generating element is configured to generate a surface acoustic wave based on an inputted electric signal. The surface acoustic wave detecting element is configured to receive the surface acoustic wave to generate an output electric signal. The bend of the flexible base causes a change of at least one characteristic of the surface acoustic wave, and causes a change of the output electric signal, so as to detect the bend based on the change of output electric signal.

In one or more embodiments of the present disclosure, the at least one characteristic includes at least one of a frequency, a phase, and an amplitude.

In all embodiments of the present disclosure, the surface acoustic wave generating element and the surface acoustic wave detecting element include a piezoelectric layer, and an interdigital electrode positioned on the piezoelectric layer.

In one or more embodiments of the present disclosure, a material of the piezoelectric layer includes any one of ZnO, AlN, and c-BN.

In one or more embodiments of the present disclosure, the flexible substrate further includes a reflective element positioned on at least one of following locations: a side of the surface acoustic wave generating element away from the surface acoustic wave detecting element; and a side of the surface acoustic wave detecting element away from the surface acoustic wave generating element.

In one or more embodiments of the present disclosure, the reflective element is positioned on the piezoelectric layer.

In one or more embodiments of the present disclosure, the flexible substrate further includes a sound absorbing material positioned on at least one of following locations: a side of the surface acoustic wave generating element away from the surface acoustic wave detecting element; and a side of the surface acoustic wave detecting element away from the surface acoustic wave generating element.

In one or more embodiments of the present disclosure, the sound absorbing material is positioned on the piezoelectric layer.

In all embodiments of the present disclosure, the flexible base is provided with a plurality of thin film transistors arranged in an array. The surface acoustic wave generating element and the surface acoustic wave detecting element are positioned between adjacent thin film transistors.

In one or more embodiments of the present disclosure, a source/drain electrode of the thin-film transistor and the interdigital electrode are formed by the same material.

In all embodiments of the present disclosure, the flexible substrate further includes a passivation layer having a first portion positioned in a region where the thin film transistors are positioned and a second portion positioned in a region between the adjacent thin film transistors. The surface acoustic wave generating element and the surface acoustic wave detecting element are positioned on the second portion.

In all embodiments of the present disclosure, the passivation layer includes a first passivation layer and a second passivation layer positioned on the first passivation layer. The flexible substrate further includes a lead positioned on the second portion of the first passivation layer. The surface acoustic wave generating element and the surface acoustic wave detecting element are electrically connected to the lead through a via in the second passivation layer.

In one or more embodiments of the present disclosure, the flexible substrate further includes a planarization layer covered on the surface acoustic wave generating element and the surface acoustic wave detecting element.

At a second aspect of the present disclosure, there is provided a flexible OLED display device. The flexible OLED display device includes the flexible substrate according to the present disclosure, such as the flexible substrate according to one or more embodiments disclosed above and/or below in more detail.

In all embodiments of the present disclosure, the flexible OLED display device further includes a driver connected to the surface acoustic wave generating element and configured to drive the surface acoustic wave generating element to generate the surface acoustic wave, and a processing unit connected to the surface acoustic wave detecting element and configured to process the output electric signal of the surface acoustic wave detecting element.

At a third aspect of the present disclosure, there is provided a method for fabricating a flexible substrate according to claim 10, comprising, inter alia: providing a flexible base; and forming a surface acoustic wave generating element and a surface acoustic wave detecting element on the flexible base. The surface acoustic wave generating element and the surface acoustic wave detecting element are configured to detect a bend of the flexible substrate.

In all embodiments of the present disclosure, forming the surface acoustic wave generating element and the surface acoustic wave detecting element includes: forming a piezoelectric layer on the flexible base; and forming an interdigital electrode on the piezoelectric layer.

In all embodiments of the present disclosure, providing the flexible base includes: forming a plurality of thin film transistors arranged in an array on the flexible base; and forming a passivation layer on the flexible base and the plurality of thin film transistors. The passivation layer has a first portion positioned in a region where the thin film transistors are positioned and a second portion positioned in a region between the adjacent thin film transistors of the flexible base. Forming the piezoelectric layer on the flexible base includes: forming the piezoelectric layer on the second portion of the passivation layer.

In all embodiments of the present disclosure, the passivation layer includes a first passivation layer and a second passivation layer positioned on the first passivation layer. Providing the flexible base further includes: forming a lead on the second portion of the first passivation layer. Forming the surface acoustic wave generating element and the surface acoustic wave detecting element further includes: forming a first via penetrating through the piezoelectric layer and the second portion of the second passivation layer and reaching the lead, before forming the interdigital electrode. Forming the interdigital electrode includes: forming a first conducting layer on the piezoelectric layer and in the first via, and patterning the first conducting layer to form the interdigital electrode.

In one or more embodiments of the present disclosure, the method further includes: forming a second via penetrating through the first portion of the passivation layer and reaching a source/drain region of the thin film transistor while forming the first via. The first conducting layer further fills the second via, and the patterning the first conducting layer further forms a source/drain electrode of the thin film transistor.

At a fourth aspect of the present disclosure, there is provided a method for detecting a bend of the flexible substrate according to the present disclosure. The method includes: inputting an electric signal to the surface acoustic wave generating element to generate a surface acoustic wave, wherein the bend of the flexible base causes a change of at least one characteristic of the surface acoustic wave; receiving the surface acoustic wave by the surface acoustic wave detecting element to generate an output electric signal, wherein the output electric signal changes based on the change of the at least one characteristic of the surface acoustic wave; and detecting the bend based on the change of the output electric signal.

Further aspects and areas of applicability will become apparent from the description provided herein. It should be understood that various aspects of this application may be implemented individually or in combination with one or more other aspects. It should also be understood that the description and specific examples herein are intended for purposes of illustration only and are not intended to limit the scope of the present application as defined by the claims.

### BRIEF DESCRIPTION OF DRAWINGS

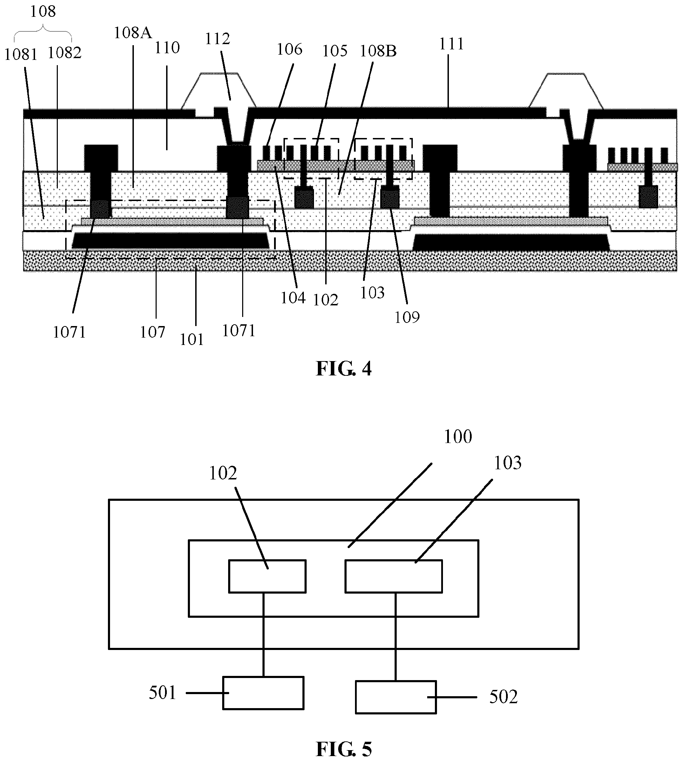

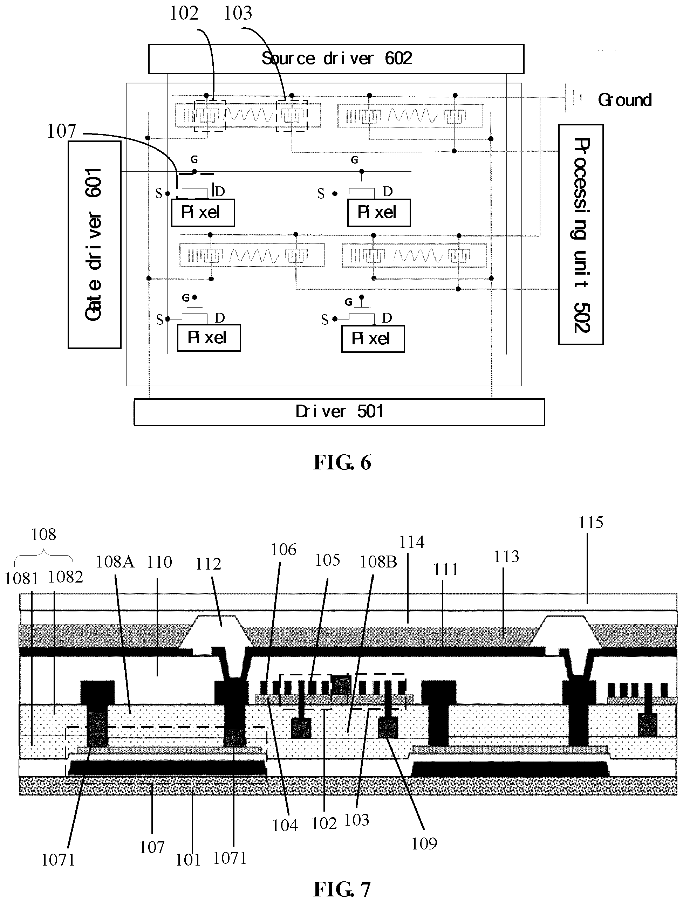

Figures 4 and 7 show embodiments of the present invention. 1-3,5-6,8-10 show further examples which are not encompassed in the scope of the invention, even if they are named "embodiments" in the corresponding parts of the description. The scope of protection is defined by the claims.
FIG. 1 schematically illustrates an exemplary sectional view of a flexible substrate according to an example of the present disclosure;
FIG. 2A schematically illustrates an exemplary structural diagram of a flexible substrate according to an example of the present disclosure;
FIG. 2B schematically illustrates an exemplary structural diagram of another flexible substrate according to an example of the present disclosure;
FIG. 3 illustrates a schematic diagram of a change of a surface acoustic wave when a piezoelectric layer is bent according to an example of the present disclosure;
FIG. 4 schematically illustrates a sectional view of another flexible substrate according to an embodiment of the present disclosure;
FIG. 5 schematically illustrates an exemplary block diagram of a flexible OLED display device according to an example of the present disclosure;
FIG. 6 schematically illustrates a drive circuit diagram of a flexible OLED display device according to an example of the present disclosure;
FIG. 7 schematically illustrates a sectional view of another flexible OLED display device according to an embodiment of the present disclosure;
FIG. 8 schematically illustrates a flowchart of a method for fabricating a flexible substrate according to an example of the present disclosure;
FIG. 9 schematically illustrates a flowchart of a method for fabricating the flexible substrate in FIG. 4 according to an example of the present disclosure; and
FIG. 10 schematically illustrates a flowchart of a method for detecting a bend of a flexible substrate according to an example of the present disclosure.

Corresponding reference numerals indicate corresponding parts or features throughout the several views of the drawings.

### DETAILED DESCRIPTION

Various embodiments will now be described in detail with reference to the drawings, which are provided as illustrative examples of the disclosure so as to enable those skilled in the art to practice the disclosure. Notably, the figures and the examples below are not meant to limit the scope of the present disclosure which is defined by the claims. Where certain elements of the present disclosure may be partially or fully implemented using known components (or methods or processes), only those portions of such known components (or methods or processes) that are necessary for an understanding of the present disclosure will be described, and the detailed descriptions of other portions of such known components will be omitted so as not to obscure the disclosure.

For purposes of the description hereinafter, the terms "upper", "lower", "right", "left", "vertical", "horizontal", "top", "bottom", and derivatives thereof shall relate to the disclosure, as it is oriented in the drawing figures. The terms "overlying", "atop", "positioned on " or "positioned atop" means that a first element, such as a first structure, is present on a second element, such as a second structure, wherein intervening elements, such as an interface structure, e.g. interface layer, may be present between the first element and the second element. The term "direct contact" means that a first element, such as a first structure, and a second element, such as a second structure, are connected without any intermediary conducting, insulating or semiconductor layers at the interface of the two elements.

As used herein, the expressions "have", "comprise" and "contain" as well as grammatical variations thereof are used in a non-exclusive way. Thus, the expression "A has B" as well as the expression "A comprises B" or "A contains B" may both refer to the fact that, besides B, A contains one or more further components and/or constituents, and to the case in which, besides B, no other components, constituents or elements are present in A.

As used herein and in the appended claims, the singular form of a word includes the plural, and vice versa, unless the context clearly dictates otherwise. Thus, singular words are generally inclusive of the plurals of the respective terms.

In addition to the foregoing advantages, the bendable characteristic of the flexible display also may provide a convenient human-computer interaction mode. Such interaction mode may be implemented by way of bend feedback. As an example, when an E-book is being read, the screen may be bent to a certain degree, and E-book page flipping may be controlled by detecting the degree of bend. Such bend detection function not only may provide an additional interaction mode, but also may implement function control by bending the screen with a glove worn.

At a first aspect of the present disclosure, there is provided a flexible substrate, a bend of which may be detected to provide an additional human-computer interaction.

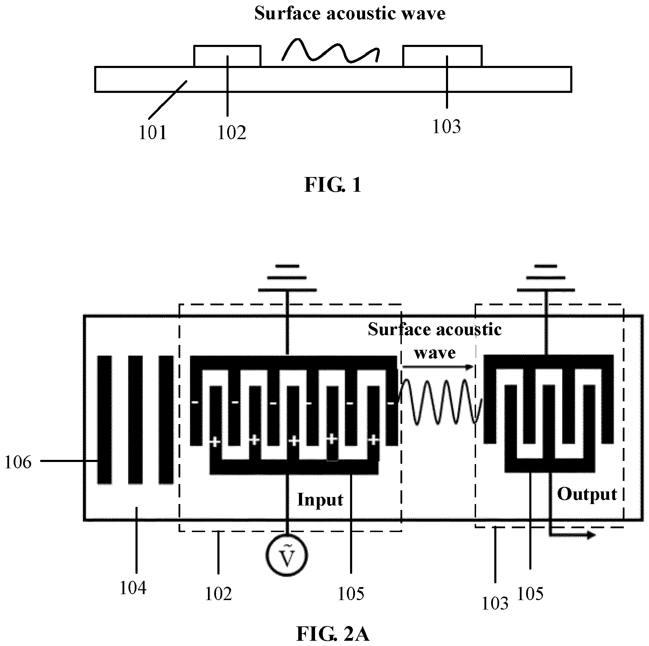

FIG. 1 schematically illustrates an exemplary sectional view of the flexible substrate according to an embodiment of the present disclosure. As shown in FIG. 1, the flexible substrate may include a flexible base 101, and a surface acoustic wave generating element 102 and a surface acoustic wave detecting element 103 positioned on the flexible base 101. The surface acoustic wave generating element 102 and the surface acoustic wave detecting element 103 are configured to detect a bend of the flexible substrate.

In an embodiment of the present disclosure, the bend of the flexible substrate may cause a change of a characteristic of the surface acoustic wave. Therefore, the bend of the flexible substrate may be detected based on the change of the surface acoustic wave caused by the bend of the flexible substrate. In the case where the flexible substrate is applied to a flexible display device, the bend detection function of the flexible substrate may provide the additional human-computer interaction mode. As an example, E-book page flipping may be carried out when the bend is detected. As another example, by means of the bend detection function provided by the flexible substrate, a degree of bend of the substrate may be detected to prevent the substrate from being damaged due to overbending.

In an embodiment of the present disclosure, the surface acoustic wave generating element 102 may be configured to generate a surface acoustic wave based on an inputted electric signal. The surface acoustic wave detecting element 103 may be configured to receive the surface acoustic wave to generate an output electric signal. The bend of the flexible base may cause a change of at least one characteristic of the surface acoustic wave, and then may cause a change of the output electric signal, so as to detect the bend based on the change of output electric signal. As an example, the at least one characteristic of the surface acoustic wave may be one or more of a phase, a frequency, and an amplitude.

In an embodiment of the present disclosure, the flexible base 101 may be formed by a polymer material such as PET, PEN and polyimide.

FIG. 2A schematically illustrates an exemplary structural diagram of the flexible substrate according to an embodiment of the present disclosure. As shown in FIG. 2A, the surface acoustic wave generating element 102 may be an input interdigital transducer, and the surface acoustic wave detecting element 103 may be an output interdigital transducer. By way of example, each of the surface acoustic wave generating element 102 (for example, the input interdigital transducer) and the surface acoustic wave detecting element 103 (for example, the output interdigital transducer) may include a piezoelectric layer 104 and an interdigital electrode 105 positioned on the piezoelectric layer 104.

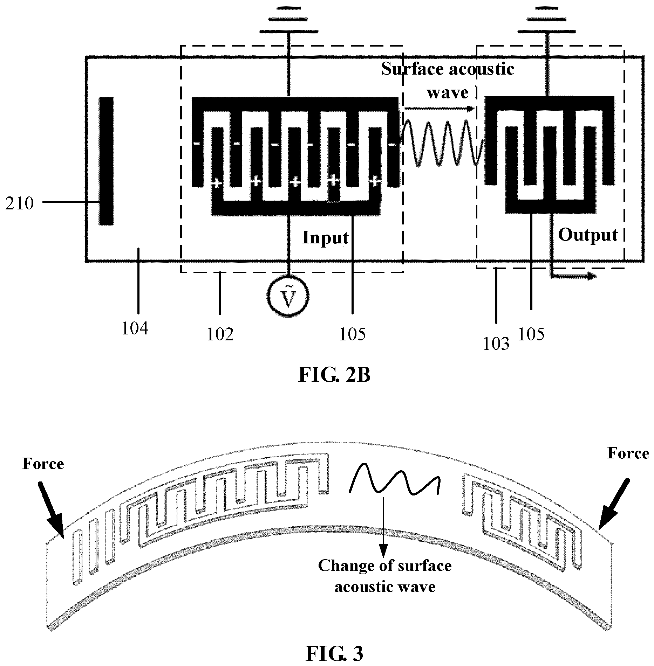

It is to be understood that in embodiments of the present disclosure, the surface acoustic wave generating element 102 is not limited to the input interdigital transducer as shown in FIG. 2, and any element capable of generating a surface acoustic wave may serve as the surface acoustic wave generating element 102. Likewise, the surface acoustic wave detecting element 103 is either not limited to the output interdigital transducer as shown in FIG. 2, and any element capable of converting a surface acoustic wave into an electric signal may serve as the surface acoustic wave detecting element 103.

In an embodiment of the present disclosure, an input electric signal may be applied to the input interdigital transducer, and the input interdigital transducer may convert the input electric signal into a surface acoustic wave signal based on an inverse piezoelectric effect. The surface acoustic wave signal propagates to the output interdigital transducer along the surface of the piezoelectric layer and is received by the output interdigital transducer. The output interdigital transducer converts the surface acoustic wave signal into an electric signal, and outputs the electric signal to for example a processing unit.

FIG. 3 illustrates a schematic diagram of a change of the surface acoustic wave when the piezoelectric layer is bent according to an embodiment of the present disclosure. As shown in FIG. 3, in the case where the piezoelectric layer is subject to an external influence, for example, a stress generated by the bend of the flexible substrate, a characteristic (for example, a frequency, a phase or an amplitude) of the surface acoustic wave propagating on the surface of the piezoelectric layer is changed, which may cause a change of an output electric signal from the output interdigital transducer. The bend of the flexible substrate bearing the piezoelectric layer may be obtained by analyzing the change of the output electric signal. Therefore, the flexible substrate provided by embodiments of the present disclosure may detect the bend of the flexible substrate to provide an additional human-computer interaction mode based on a degree and/or direction of the bend. Moreover, the degree of the bend may be detected based on the bend to prevent the flexible substrate from being damaged due to overbending.

In an embodiment of the present disclosure, the interdigital electrode 105 may be made from metal or metal alloy, such as aluminum or aluminum alloy. As an example, the aluminum alloy may be aluminum-copper alloy (wherein copper accounts for 25% of the total amount of the aluminum-copper alloy) or aluminum-titanium alloy (wherein titanium accounts for 25% of the total amount of the aluminum-titanium alloy).

A material of the piezoelectric layer 104 may include any one of ZnO, AlN, and c-BN. Parameters of several materials used for the piezoelectric layer are listed in Table I, for example, sound velocity, mass density, lattice constant, elastic modulus, and thermal conductivity.

**Table I: Materials of the Piezoelectric Layer**

| Piezoelectric materials | Sound velocity | Mass density | Lattice constant | Elastic modulus | Thermal conductivity |
|---|---|---|---|---|---|
| | (m/s) | (g/cm³) | (nm) | (Gpa) | (W/cm/K) |
| ZnO | 2600-3000 | 5.68 | 0.32498 | 211 | 0.54 |
| AlN | 5500-6100 | 3.26 | 0.3082 | 308 | 2.6 |
| c-BN | 8000-10000 | 3.48 | 0.3615 | 830 | 13 |

In an embodiment of the present disclosure, the flexible substrate may further include a reflective element 106, which may be positioned on a side of the surface acoustic wave generating element 102 away from the surface acoustic wave detecting element 103. By arranging the reflective element 106, the surface acoustic wave generated by the input interdigital transducer may be reflected to the output interdigital transducer to reduce loss of the surface acoustic wave. As shown in FIG. 2A or FIG. 3, the reflective element 106 may be positioned on a side of the input interdigital transducer away from the output interdigital transducer. That is, the input interdigital transducer is positioned between the reflective element and the output interdigital transducer. In this embodiment, in the case where a portion of the surface acoustic wave generated by the input interdigital transducer propagates toward a direction away from the output interdigital transducer, this portion of the surface acoustic wave may be reflected to the output interdigital transducer, such that the output interdigital transducer may receive this portion of the surface acoustic wave.

Alternatively, the reflective element 106 also may be arranged on a side of the surface acoustic wave detecting element 103 away from the surface acoustic wave generating element 102. That is, the surface acoustic wave detecting element 103 may be positioned between the surface acoustic wave generating element 102 and the reflective element 106. Alternatively, the reflective element 106 may be arranged both on the side of the surface acoustic wave generating element 102 away from the surface acoustic wave detecting element 103 and on the side of the surface acoustic wave detecting element 103 away from the surface acoustic wave generating element 102.

In an exemplary embodiment of the present disclosure, the reflective element 106 may be arranged in a form of a reflective grating, as shown in FIG. 2A. In this case, the reflective element 106 also may be configured to generate a resonance oscillation of the surface acoustic wave generated by the surface acoustic wave generating element 102 to enhance the surface acoustic wave signal.

In an embodiment of the present disclosure, the reflective element 106 may be arranged on the piezoelectric layer 104. The reflective element 106 may be made from the same material as the interdigital electrode 105. As an example, the reflective element 106 may be made from a metallic material. With this configuration, the interdigital electrode 105 and the reflective element 106 may be simultaneously formed by using one-step patterning process.

FIG. 2B schematically illustrates an exemplary structural diagram of another flexible substrate according to an embodiment of the present disclosure. In the embodiment as shown in FIG. 2B, a sound absorbing material 210 is employed to replace the reflective element 106 in the embodiment as shown in FIG. 2A, whereas other structures are the same as the flexible substrate in the embodiment as shown in FIG. 2A. As shown in FIG. 2B, the sound absorbing material 210 may be arranged on a side of the surface acoustic wave generating element 102 away from the surface acoustic wave detecting element 103. It may be understood that the sound absorbing material 210 also may be arranged on a side of the surface acoustic wave detecting element 103 away from the surface acoustic wave generating element 102. Alternatively, the sound absorbing material 210 also may be arranged both on the side of the surface acoustic wave generating element 102 away from the surface acoustic wave detecting element 103 and the side of the surface acoustic wave detecting element 103 away from the surface acoustic wave generating element 102.

By arranging the sound absorbing material 210, unemployed surface acoustic wave may be absorbed, such that signal interference between adjacent devices may be prevented.

FIG. 4 schematically illustrates a sectional view of another flexible substrate according to an embodiment of the present disclosure. In the embodiment as shown in FIG. 4, the flexible substrate 200 may be a backplate of a flexible OLED display.

It is to be noted that in the embodiment as shown in FIG. 4, the flexible substrate likewise includes the flexible base 101, the surface acoustic wave generating element 102, the surface acoustic wave detecting element 103, and the reflective element 106 as in the embodiment shown in FIG. 1. Therefore, reference may be made to the embodiment as shown in FIG. 1 with respect to the explanation or description of these parts in this embodiment.

As shown in FIG. 4, the flexible substrate may further include a plurality of thin film transistors (TFT) 107 arranged in an array on the flexible base 101. The surface acoustic wave generating element 102 and the surface acoustic wave detecting element 103 are positioned between the adjacent thin film transistors 107.

Each of the thin film transistors 107 may include a gate on the flexible base 101, a gate insulation layer on the gate and a region between the adjacent thin film transistors 107 of the flexible base 101, and a source/drain region and a channel region on the gate insulation layer.

In an embodiment of the present disclosure, the flexible substrate may further include a source/drain electrode 1071 electrically contacting the source/drain region of the thin film transistor. The source/drain electrode 1071 and the interdigital electrode 105 may be formed by the same material such as metal. With this configuration, the source/drain electrode and the interdigital electrode may be simultaneously fabricated by using one-step patterning process.

In the embodiment as shown in FIG. 4, the flexible substrate may further include a passivation layer 108 having a first portion 108A positioned in a region where the thin film transistors 107 are positioned and a second portion 108B positioned in a region between the adjacent thin film transistors 107 of the flexible base 101. The surface acoustic wave generating element 102 and the surface acoustic wave detecting element 103 may be positioned on the second portion 108B of the passivation layer 108.

Further referring to FIG. 4, the passivation layer 108 may include a first passivation layer 1081 and a second passivation layer 1082 positioned on the first passivation layer 1081.

As an example, both the first passivation layer 1081 and the second passivation layer 1082 may include SiO, SiN, or a lamination layer thereof.

In this embodiment, the flexible substrate may further include a lead 109 positioned on the second portion 108B of the first passivation layer 1081, and the surface acoustic wave generating element 102 and the surface acoustic wave detecting element 103 may electrically contact the lead 109 through a via in the second passivation layer 1082.

Further, as shown in FIG. 4, the flexible substrate may further include a planarization layer 110 covered on the surface acoustic wave generating element 102 and the surface acoustic wave detecting element 103 to prevent outside environment from having a negative effect on the ultrasonic wave signal. In an exemplary embodiment, the planarization layer 110 may be covered on the second passivation layer 1082, the source/drain electrode 1071, and the interdigital electrode 105.

Further, as shown in FIG. 4, the flexible substrate may further include a conducting layer 111 positioned on the planarization layer 110 and a pixel defining layer 112 formed on the conducting layer 111.

The planarization layer 110 may include a photoresist, which can prevent negative effects on the surface acoustic wave generating element 102 and the surface acoustic wave detecting element 103.

The conducting layer 111 electrically contacts the source/drain electrode 1071 through a via in the planarization layer 110, and the conducting layer 111 may serve as an anode electrode of the flexible OLED display device.

A vertical projection of the pixel defining layer 112 covers the via in the planarization layer 110. In the case where the flexible substrate in embodiments of the present disclosure is used as a backplate of the OLED display device, the pixel defining layer 112 may define a pixel region of the flexible OLED display device, such that an organic light-emitting material may be deposited in the pixel region.

At a second aspect of the present disclosure, there is provided a flexible OLED display device. Alternatively, the flexible OLED display device may include the flexible substrate according to the present disclosure, such as the flexible substrate according to one or more embodiments disclosed above and/or below in more detail. Therefore, reference may be made to embodiments of the flexible substrate for an alternative embodiment of the flexible OLED display device.

FIG. 5 schematically illustrates an exemplary block diagram of the flexible OLED display device according to an embodiment of the present disclosure. As shown in FIG. 5, the flexible OLED display device may include the flexible substrate 100 according to the present disclosure.

In an embodiment of the present disclosure, the flexible OLED display device may further include a driver 501 connected to the surface acoustic wave generating element 102 and configured to drive the surface acoustic wave generating element 102 to generate the surface acoustic wave, and a processing unit 502 connected to the surface acoustic wave detecting element 103 and configured to receive and process the output electric signal from the surface acoustic wave detecting element 103.

Typically, an operating frequency of the surface acoustic wave generating element 102 ranges from several tens of MHZ to several GHZ, which is greater than a drive frequency of the thin film transistor. Therefore, in an embodiment of the present disclosure, the driver 501 configured to drive the surface acoustic wave generating element to generate the surface acoustic wave may be separately arranged.

FIG. 6 schematically illustrates a drive circuit diagram of the flexible OLED display device according to an embodiment of the present disclosure. As shown in FIG. 6, the surface acoustic wave generating element 102 and the surface acoustic wave detecting element 103 may be positioned in a region, where no thin film transistor 107 is arranged, in each pixel region of the display device. The driver 501 may be electrically connected to the interdigital electrode of the surface acoustic wave generating element 102, and is configured to drive the surface acoustic wave generating element 102 to generate a surface acoustic wave. The processing unit 502 may be electrically connected to the interdigital electrode of the surface acoustic wave detecting element 103, and is configured to receive and process the output electric signal from the surface acoustic wave detecting element 103 to determine the bend of the flexible OLED display device. Furthermore, as shown in FIG. 6, the flexible OLED display device according to an embodiment of the present disclosure may further include a gate driver 601 electrically connected to a gate (G) of the thin film transistor, and a source driver 602 electrically connected to a source (S) of the thin film transistor 107. In embodiments of the present disclosure, the gate driver 601 provides a drive signal to the thin film transistor, and the source driver 602 provides a data signal to the thin film transistor.

In embodiments of the present disclosure, the processing unit 502 may be implemented as a combination of a processor and a memory, wherein the processor executes a program stored in the memory to implement a functionality of the processing unit. The gate driver 601, the source driver 602 and the driver 501 either may be implemented only by way of a hardware circuit, such as, an analog circuit or a digital circuit, or may be implemented by a combination of a circuit and a software and/or a firmware, such as for example, a digital signal processor, software and a memory working together to trigger various functions to be executed.

FIG. 7 schematically illustrates a sectional view of another flexible OLED display device according to an embodiment of the present disclosure. In the embodiment as shown in FIG. 7, the flexible OLED display device includes the flexible substrate in the embodiment as shown in FIG. 4, an organic light emitting layer 113 positioned in the pixel region defined by the pixel defining layer 112, a cathode layer 114 positioned on the organic light emitting layer 113 and the pixel defining layer 112, and a buffer layer 115 positioned on the cathode layer 114.

According to embodiments of the present disclosure, the bend of the flexible OLED display device may be detected based on the change of the surface acoustic wave caused by the bend of the flexible OLED display device. With this configuration, an additional human-computer interaction mode may be provided for the flexible OLED display device, for example, an E-book page flipping operation when the bend is detected. Moreover, by means of the bend detection function, a degree of bend of the flexible OLED display device may be detected to prevent the flexible OLED display device from being damaged due to overbending.

At a third aspect of the present disclosure, there is provided a method for fabricating a flexible substrate. Alternatively, this method may be used for fabricating the flexible substrate according to the present disclosure, such as the flexible substrate according to one or more embodiments disclosed above and/or below in more detail. Therefore, reference may be made to the embodiments of the flexible substrate for alternative embodiments of the method. The method may include the following steps, which may be performed in given order or in a different order. Furthermore, additional method steps not listed may be provided which are not listed. Furthermore, two or more or event all of the method steps may be performed at least partially simultaneously. Furthermore, a method step may be performed twice or even more than twice, repeatedly.

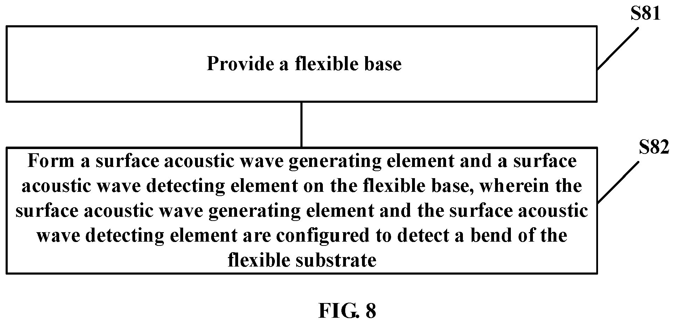

FIG. 8 schematically illustrates a flowchart of a method for fabricating a flexible substrate according to an embodiment of the present disclosure. As shown in FIG. 8, the method includes Step S81 and Step S82. In Step S81, a flexible base is provided. In Step S82, a surface acoustic wave generating element and a surface acoustic wave detecting element are formed on the flexible base. The surface acoustic wave generating element and the surface acoustic wave detecting element are configured to detect a bend of the flexible substrate.

In Step S81 as shown in FIG. 8, providing the flexible base may include: forming a plurality of thin film transistors arranged in an array on the flexible base; and forming a passivation layer on the flexible base and the plurality of thin film transistors. In this embodiment, the passivation layer has a first portion positioned on the thin film transistors and a second portion positioned in a region between the adjacent thin film transistors of the flexible base.

In Step S82 as shown in FIG. 8, forming the surface acoustic wave generating element and the surface acoustic wave detecting element may include: forming a piezoelectric layer on the flexible base; and forming an interdigital electrode on the piezoelectric layer. In this embodiment, the piezoelectric layer may be formed on the second portion of the passivation layer, such that the surface acoustic wave generating element and the surface acoustic wave detecting element are formed between the adjacent thin film transistors.

In an embodiment of the present disclosure, the passivation layer may include a first passivation layer and a second passivation layer positioned on the first passivation layer. Providing the flexible base may further include: forming a lead on the second portion of the first passivation layer. Further, forming the surface acoustic wave generating element and the surface acoustic wave detecting element may further include: forming a first via penetrating through the piezoelectric layer and the second portion of the second passivation layer and reaching the lead, before forming the interdigital electrode. Further, forming the interdigital electrode may include: forming a first conducting layer on the piezoelectric layer and in the first via, and patterning the first conducting layer to form the interdigital electrode. The interdigital electrode electrically contacts the lead through the conducting layer in the first via.

In an embodiment of the present disclosure, the method for fabricating the flexible substrate may further include: forming a second via penetrating through the first portion of the passivation layer and reaching a source/drain region of the thin film transistor while forming the first via. In this embodiment, the first conducting layer fills the second via. Patterning the first conducting layer further forms a source/drain electrode of the thin film transistor. That is, the interdigital electrode and the source/drain electrode may be formed in one-step patterning process. Therefore, the method for fabricating the flexible substrate provided by this embodiment of the present disclosure is relatively simple in process.

In an embodiment of the present disclosure, the method for fabricating the flexible substrate may further include: forming a planarization layer covering the second passivation layer, the source/drain electrode and the interdigital electrode; forming a third via exposing the source/drain electrode in the planarization layer; forming a second conducting layer on the planarization layer and in the third via; and forming a pixel defining layer on the second conducting layer, wherein a vertical projection of the pixel defining layer covers the second via.

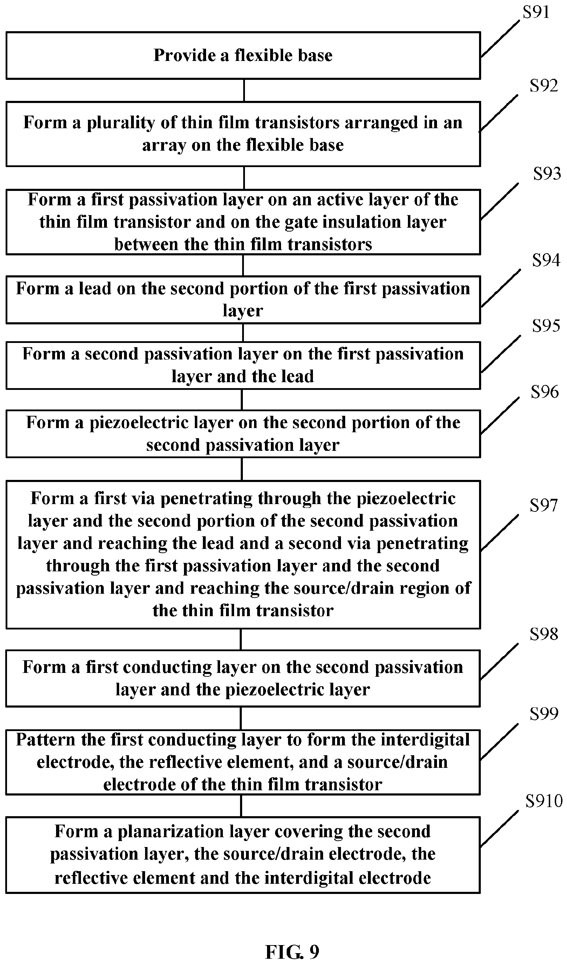

FIG. 9 schematically illustrates a flowchart of a method for fabricating the flexible substrate in FIG. 4 according to an embodiment of the present disclosure. As an example, in the embodiment as shown in FIG. 9, the fabricated flexible substrate may be used as a backplate of the flexible OLED display device. As shown in FIG. 9, the method may include Steps S91-S910.

In Step S91, a flexible base 101 is provided. The flexible base 101 may be formed by a polymer material such as PET, PEN and polyimide.

In Step S92, a plurality of thin film transistors 107 arranged in an array are formed on the flexible base 101. In embodiments of the present disclosure, each of the thin film transistors 107 may include a gate, a gate insulation layer, an active layer (including a source/drain region and a channel region).

In Step S93, a first passivation layer 1081 is formed on the active layer of the thin film transistor 107 and on the gate insulation layer between the adjacent thin film transistors. The first passivation layer 1081 includes a first portion 108A positioned on the thin film transistor 107 and a second portion 108B between the adjacent thin film transistors 107. The material of the first passivation layer 1081 may be, for example, SiO, SiN, or a combination of SiO and SiN.

In Step S94, a lead 109 is formed on the second portion 108B of the first passivation layer 1081. In embodiments of the present disclosure, the lead 109 may be formed by way of sputtering, evaporation, and so on.

In Step S95, a second passivation layer 1082 is formed on the first passivation layer 1081 and the lead 109. The second passivation layer 1082 includes a first portion 108A positioned on the thin film transistor 107 and a second portion 108B between the adjacent thin film transistors 108. The material of the second passivation layer 1082 may be, for example, SiO, SiN, or a combination of SiO and SiN.

In Step S96, a piezoelectric layer 104 is formed on the second portion 108B of the second passivation layer 1082. The material of the piezoelectric layer 104 may include, for example, any one of ZnO, AlN, and c-BN.

In Step S97, a first via penetrating through the piezoelectric layer 104 and the second portion 108B of the second passivation layer 1082 and reaching the lead 109 and a second via penetrating through the first passivation layer 1081 and the second passivation layer 1082 and reaching the source/drain region of the thin film transistor 107 are formed.

In Step S98, a first conducting layer is formed on the second passivation layer 1082 and the piezoelectric layer 104, and the first conducting layer electrically contacts the lead 109 and the source/drain region through the first via and the second via, respectively.

In Step S99, the first conducting layer is patterned to form the interdigital electrode 105, the reflective element 106, and a source/drain electrode 1071 of the thin film transistor.

In Step S910, a planarization layer 110 covering the second passivation layer 1082, the source/drain electrode 1071, the reflective element 106 and the interdigital electrode 105 is formed.

In the embodiment as shown in FIG. 9, only steps required for understanding the present disclosure are illustrated. It may be understood that the method in the embodiment as shown in FIG. 9 may further include steps of forming other known parts or components required. In a non-limiting embodiment, the method for fabricating the flexible substrate may further include: forming a third via exposing the source/drain electrode 1071 in the planarization layer 110; forming a second conducting layer 111 on the planarization layer 110 and in the third via; and forming a pixel defining layer 112 on the second conducting layer 111. The pixel defining layer 112 fills the third via, and the vertical projection of the pixel defining layer 112 covers the third via. Detailed description of these steps is omitted in this embodiment.

At a fourth aspect of the present disclosure, there is provided a method for detecting a bend of a flexible substrate. Alternatively, this method may be used to detect the bend of the flexible substrate according to the present disclosure, such as the flexible substrate according to one or more embodiments disclosed above and/or below in more detail. Therefore, reference may be made to the embodiments of the flexible substrate for alternative embodiments of the method.

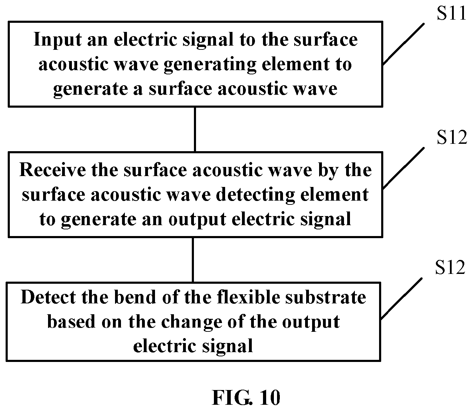

FIG. 10 schematically illustrates a flowchart of a method for detecting a bend of a flexible substrate according to an embodiment of the present disclosure. As shown in FIG. 10, this method includes Steps S11-S13.

In Step S11, an electric signal is inputted to the surface acoustic wave generating element to generate a surface acoustic wave. In embodiments of the present disclosure, the bend of the flexible base may cause a change of at least one characteristic of the surface acoustic wave.

The surface acoustic wave generating element may be, for example, a surface acoustic wave input interdigital transducer. The inputted electric signal may allow the input interdigital transducer to generate a surface acoustic wave on a surface of the piezoelectric layer based on an inverse piezoelectric effect, wherein the surface acoustic wave propagates on the surface of the piezoelectric layer. When the piezoelectric layer is subject to an external influence (for example, a stress generated by the bend of the flexible base), at least one characteristic of the surface acoustic wave may be changed. The at least one characteristic may include at least one of a frequency, a phase, and an amplitude.

In Step S12, the surface acoustic wave is received by the surface acoustic wave detecting element to generate an output electric signal. In embodiments of the present disclosure, the output electric signal changes based on the change of the at least one characteristic of the surface acoustic wave.

The surface acoustic wave detecting element may be, for example, a surface acoustic wave output interdigital transducer. The output interdigital transducer may convert the received surface acoustic wave signal into the output electric signal based on the piezoelectric effect. When the at least one characteristic of the surface acoustic wave changes due to the bend of the flexible substrate, the output electric signal may change with the change of the surface acoustic wave.

In Step S13, the bend of the flexible substrate is detected based on the change of the output electric signal.

In embodiments of the present disclosure, the output electric signal changes with the change of the surface acoustic wave. Therefore, the change of the surface acoustic wave may be obtained by processing and analyzing the output electric signal, and then a bending stress distribution of the flexible substrate may be obtained based on the change of the surface acoustic wave, so as to give a feedback based on the bending stress distribution. As an example, in the case where it is detected that a bending stress is too large, a user is reminded to prevent the flexible substrate from being damaged. Alternatively, in the case where a back bend is detected, an additional human-computer interaction mode is provided, for example, E-book page flipping.

The foregoing description of the embodiment has been provided for purpose of illustration and description. It is not intended to be exhaustive or to limit the application. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the application, and all such modifications are included within the scope of the application as defined by the claims.

## Claims

1. A flexible substrate, comprising:
a flexible base (101) provided with a plurality of thin film transistors (107) arranged in an array;
a surface acoustic wave generating element (102) and a surface acoustic wave detecting element (103) positioned on the flexible base (101),
wherein the surface acoustic wave generating element (102) and the surface acoustic wave detecting element (103) are configured to detect a bend of the flexible substrate, and
a passivation layer (108) on the flexible base (101) and the plurality of thin film transistors (107), wherein the passivation layer (108) has a first portion (108A) positioned in a region where the thin film transistors (107) are positioned and a second portion (108B) positioned in a region between the adjacent thin film transistors (107), wherein the surface acoustic wave generating element (102) and the surface acoustic wave detecting element (103) are positioned on the second portion (108B),
wherein the surface acoustic wave generating element (102) and the surface acoustic wave detecting element (103) comprise:
a piezoelectric layer (104); and
an interdigital electrode (105) positioned on the piezoelectric layer (104), and
wherein the piezoelectric layer (104) is disposed on a side of a channel region of the thin film transistors (107) away from the flexible base (101) and electrically isolated from the channel region of the thin film transistors (107) by the passivation layer (108).

2. The flexible substrate according to claim 1, wherein the surface acoustic wave generating element (102) is configured to generate a surface acoustic wave based on an inputted electric signal;
wherein the surface acoustic wave detecting element (103) is configured to receive the surface acoustic wave to generate an output electric signal; and
wherein the bend of the flexible base (101) causes a change of at least one characteristic of the surface acoustic wave, and causes a change of the output electric signal based on which the bend is detected, and optionally, the at least one characteristic comprises at least one of a frequency, a phase, and an amplitude.

3. The flexible substrate according to claim 1 or 2, wherein a material of the piezoelectric layer (104) comprises any one of ZnO, AlN, and c-BN.

4. The flexible substrate according to claim 3, further comprising a reflective element (106) positioned on at least one of following locations:
a side of the surface acoustic wave generating element (102) away from the surface acoustic wave detecting element (103), and optionally, the reflective element (106) is positioned on the piezoelectric layer (104); and
a side of the surface acoustic wave detecting element (103) away from the surface acoustic wave generating element (102), and optionally, the reflective element (106) is positioned on the piezoelectric layer (104).

5. The flexible substrate according to claim 3, further comprising a sound absorbing material (210) positioned on at least one of following locations:
a side of the surface acoustic wave generating element (102) away from the surface acoustic wave detecting element (103), and optionally, the sound absorbing material (210) is positioned on the piezoelectric layer (104); and
a side of the surface acoustic wave detecting element (103) away from the surface acoustic wave generating element (102), and optionally, the sound absorbing material (210) is positioned on the piezoelectric layer (104).

6. The flexible substrate according to any one of claims 3-5, wherein a source/drain electrode (1071) of the thin-film transistor and the interdigital electrode (105) are formed by the same material.

7. The flexible substrate according to claim 1, wherein the passivation layer (108) comprises a first passivation layer (1081) and a second passivation layer (1082) positioned on the first passivation layer (1081), the flexible substrate further comprises a lead (109) positioned on the second portion (108B) of the first passivation layer (1081), and the surface acoustic wave generating element (102) and the surface acoustic wave detecting element (103) are electrically connected to the lead (109) through a via in the second passivation layer (1082).

8. The flexible substrate according to any one of claims 1-7, further comprising a planarization layer (110) covered on the surface acoustic wave generating element (102) and the surface acoustic wave detecting element (103).

9. A flexible OLED display device, comprising the flexible substrate 100 according to any one of claims 1-8, optionally, the flexible OLED display device further comprising:
a driver (501) connected to the surface acoustic wave generating element (102) and configured to drive the surface acoustic wave generating element (102) to generate the surface acoustic wave; and
a processing unit (502) connected to the surface acoustic wave detecting element (103) and configured to process the output electric signal of the surface acoustic wave detecting element (103).

10. A method for fabricating a flexible substrate, comprising:
providing (S81) a flexible base (101); and
forming (S82) a surface acoustic wave generating element (102) and a surface acoustic wave detecting element (103) on the flexible base (101), wherein the surface acoustic wave generating element (102) and the surface acoustic wave detecting element (103) are configured to detect a bend of the flexible substrate,
wherein providing (S81) a flexible base (101) comprises:
forming a plurality of thin film transistors (107) arranged in an array on the flexible base (101); and
forming a passivation layer (108) on the flexible base (101) and the plurality of thin film transistors (107),
wherein forming (S82) the surface acoustic wave generating element (102) and the surface acoustic wave detecting element (103) comprises:
forming a piezoelectric layer (104) on the flexible base (101); and
forming an interdigital electrode (105) on the piezoelectric layer (104),
and wherein the piezoelectric layer (104) is formed on a side of a channel region of the thin film transistors (107) away from the flexible base (101) and electrically isolated from the channel region of the thin film transistors (107) by the passivation layer (108),
wherein the passivation layer (108) has a first portion (108A) positioned in a region where the thin film transistors (107) are positioned and a second portion (108B) positioned in a region between the adjacent thin film transistors (107) of the flexible base (101), and wherein
forming the piezoelectric layer (104) on the flexible base (101) comprises:
forming the piezoelectric layer (104) on the second portion (108B) of the passivation layer (108).

11. The method according to claim 10, wherein the passivation layer (108) comprises a first passivation layer (1081) and a second passivation layer (1082) positioned on the first passivation layer (1081),
wherein providing the flexible base (101) further comprises:
forming a lead (109) on the second portion (108B) of the first passivation layer (1081),
wherein forming the surface acoustic wave generating element (102) and the surface acoustic wave detecting element (103) further comprises:
forming a first via penetrating through the piezoelectric layer (104) and the second portion (108B) of the second passivation layer (1082) and reaching the lead (109), before forming the interdigital electrode (105), and
wherein forming the interdigital electrode (105) comprises:
forming a first conducting layer (111) on the piezoelectric layer (104) and in the first via, and
patterning the first conducting layer (111) to form the interdigital electrode (105),
optionally, the method further comprising:
forming a second via penetrating through the first portion (108A) of the passivation layer (108) and reaching a source/drain region of the thin film transistor (107) while forming the first via, wherein the first conducting layer (111) further fills the second via, and patterning the first conducting layer (111) further forms a source/drain electrode (1071) of the thin film transistor (107).

12. A method for detecting a bend of the flexible substrate according to any one of claims 1-8, comprising:
inputting (S11) an electric signal to the surface acoustic wave generating element (102) to generate a surface acoustic wave, wherein the bend of the flexible base (101) causes a change of at least one characteristic of the surface acoustic wave;
receiving (S12) the surface acoustic wave by the surface acoustic wave detecting element (103) to generate an output electric signal, wherein the output electric signal changes based on the change of the at least one characteristic of the surface acoustic wave; and
detecting (S13) the bend based on the change of the output electric signal.

## Patentansprüche

1. Flexibles Substrat mit
einer flexiblen Basis (101), die mit einer Anzahl in einem Array angeordneter Dünnfilmtransistoren (107) ausgestattet ist,
einem akustische Oberflächenwellen erzeugenden Element (102) und einem auf der flexiblen Basis (101) angeordneten akustische Oberflächenwellen erfassenden Element (103),
wobei das akustische Oberflächenwellen erzeugende Element (102) und das akustische Oberflächenwellen erfassende Element (103) dazu ausgelegt sind, eine Biegung des flexiblen Substrats zu erfassen, und
einer Passivierungsschicht (108) auf der flexiblen Basis (101) und der Anzahl Dünnfilmtransistoren (107), wobei die Passivierungsschicht (108) einen ersten Abschnitt (108A), der in einem Gebiet angeordnet ist, in dem die Dünnfilmtransistoren (107) angeordnet sind, und einen zweiten Abschnitt (108B), der in einem zwischen den angrenzenden Dünnfilmtransistoren (107) angeordnet ist, aufweist, wobei das akustische Oberflächenwellen erzeugende Element (102) und das akustische Oberflächenwellen erfassende Element (103) auf dem zweiten Abschnitt (108B) angeordnet sind,
wobei das akustische Oberflächenwellen erzeugende Element (102) und das akustische Oberflächenwellen erfassende Element (103)
eine piezoelektrische Schicht (104) und
eine auf der piezoelektrischen Schicht (104) angeordnete interdigitale Elektrode (105)
aufweisen, und
wobei die piezoelektrische Schicht (104) auf einer von der flexiblen Basis (101) abgewandten Seite eines Kanalgebiets der Dünnfilmtransistoren (107) angeordnet ist und durch die Passivierungsschicht (108) vom Kanalgebiet der Dünnfilmtransistoren (107) elektrisch isoliert ist.

2. Flexibles Substrat gemäß Anspruch 1, wobei das akustische Oberflächenwellen erzeugende Element (102) dazu ausgelegt ist, eine auf einem eingegebenen elektrischen Signal basierende akustische Oberflächenwelle zu erzeugen,
wobei das akustische Oberflächenwellen erfassende Element (103) dazu ausgelegt ist, die akustische Oberflächenwelle zu empfangen, um ein elektrisches Ausgangssignal zu erzeugen, und
wobei das Biegen der flexiblen Basis (101) eine Änderung mindestens eines Merkmals der akustischen Oberflächenwelle bewirkt und eine Änderung des elektrischen Ausgangssignals bewirkt, wodurch die Biegung entdeckt wird, und wobei das mindestens eine Merkmal mindestens eins von einer Frequenz, einer Phase und einer Amplitude aufweist.

3. Flexibles Substrat gemäß Anspruch 1 oder 2, wobei ein Material der piezoelektrischen Schicht (104) irgendeins von ZnO, AlN und c-BN aufweist.

4. Flexibles Substrat gemäß Anspruch 3, das außerdem ein reflektierendes Element (106) aufweist, das an mindestens einer der folgenden Stellen angeordnet ist:
einer von dem die akustische Oberflächenwelle erfassenden Element (103) abgewandten Seite des die akustische Oberflächenwelle erzeugenden Elements (102), wobei das reflektierende Element (106) wahlweise auf der piezoelektrischen Schicht (104 angeordnet ist, und
einer von dem die akustische Oberflächenwelle erzeugenden Element (102) abgewandten Seite des die akustische Oberflächenwelle erfassenden Elements (103), wobei das reflektierende Element (106) wahlweise auf der piezoelektrischen Schicht (104 angeordnet ist.

5. Flexibles Substrat gemäß Anspruch 3, das außerdem ein Schall absorbierendes Material (210) aufweist, das an mindestens einer der folgenden Stellen angeordnet ist:
einer von dem die akustische Oberflächenwelle erfassenden Element (103) abgewandten Seite des die akustische Oberflächenwelle erzeugenden Elements (102), wobei das Schall absorbierende Material (210) wahlweise auf der piezoelektrischen Schicht (104 angeordnet ist, und
einer von dem die akustische Oberflächenwelle erzeugenden Element (102) abgewandten Seite des die akustische Oberflächenwelle erfassenden Elements (103), wobei das Schall absorbierende Material (210) wahlweise auf der piezoelektrischen Schicht (104 angeordnet ist.

6. Flexibles Substrat gemäß einem der Ansprüche 3 bis 5, wobei eine Source/Drain-Elektrode (1071) des Dünnfilmtransistors und die interdigitale Elektrode (105) aus demselben Material gefertigt sind.

7. Flexibles Substrat gemäß Anspruch 1, wobei die Passivierungsschicht (108) eine erste Passivierungsschicht (1081) und eine auf der ersten Passivierungsschicht (1081) angeordnete zweite Passivierungsschicht (1082) aufweist, wobei das flexible Substrat außerdem eine Leitung (109) aufweist, die auf dem zweiten Abschnitt (108B) der ersten Passivierungsschicht (1081) angeordnet ist, und wobei das akustische Oberflächenwellen erzeugende Element (102) und das akustische Oberflächenwellen erfassende Element (103) durch einen Durchgang in der zweiten Passivierungsschicht (1082) mit der Leitung (109) verbunden sind.

8. Flexibles Substrat gemäß einem der Ansprüche 1 bis 7, das außerdem eine auf dem akustische Oberflächenwellen erzeugenden Element (102) und dem akustische Oberflächenwellen erfassenden Element (103) bedeckte Planarisierungsschicht (110) aufweist.

9. Flexible OLED-Anzeigevorrichtung, die das flexible Substrat (100) gemäß einem der Ansprüche 1 bis 8 aufweist, wobei die flexible OLED-Anzeigevorrichtung außerdem
einen Treiber (501), der mit dem akustische Oberflächenwellen erzeugenden Element (102) verbundenen ist und dazu ausgelegt ist, das akustische Oberflächenwellen erzeugende Element (102) zu treiben, um die akustische Oberflächenwelle zu erzeugen, und
eine Verarbeitungseinheit (502), die mit dem akustische Oberflächenwellen erfassenden Element (103) verbunden ist und dazu ausgelegt ist, das elektrische Ausgangssignal des die akustische Oberflächenwelle erfassenden Elements (103) zu verarbeiten,
aufweist.

10. Verfahren zum Herstellen eines flexiblen Substrats mit
Bereitstellen (S81) einer flexiblen Basis (101) und
Bilden (S82) eines akustische Oberflächenwellen erzeugenden Elements (102) und eines akustische Oberflächenwellen erfassenden Elements (103) auf der flexiblen Basis (101), wobei das akustische Oberflächenwellen erzeugende Element (102) und das akustische Oberflächenwellen erfassende Element (103) dazu ausgelegt sind, eine Biegung des flexiblen Substrats zu erfassen,
wobei das Bereitstellen (S81) einer flexiblen Basis (101)
Bilden einer auf der flexiblen Basis (101) in einem Array angeordneten Anzahl Dünnschichttransistoren (107) und
Bilden einer Passivierungsschicht (108) auf der flexiblen Basis (101) und der Anzahl Dünnschichttransistoren (107),
aufweist,
wobei das Bilden (S82) des akustische Oberflächenwellen erzeugenden Elements (102) und des akustische Oberflächenwellen erfassenden Elements (103) auf der flexiblen Basis (101)
Bilden einer piezoelektrischen Schicht (104) auf der flexiblen Basis (101) und
Bilden einer interdigitalen Elektrode (105) auf der piezoelektrischen Schicht (104)
aufweist,
und wobei die piezoelektrische Schicht (104) auf einer von der flexiblen Basis (101) abgewandten Seite eines Kanalgebiets der Dünnfilmtransistoren (107) angeordnet ist und durch die Passivierungsschicht (108) vom Kanalgebiet der Dünnfilmtransistoren (107) elektrisch isoliert ist,
wobei die Passivierungsschicht (108) einen ersten Abschnitt (108A), der in einem Gebiet angeordnet ist, in dem die Dünnfilmtransistoren (107) angeordnet sind, und einen zweiten Abschnitt (108B), der in einem zwischen den angrenzenden Dünnfilmtransistoren (107) angeordnet ist, aufweist, und wobei
Bilden der piezoelektrischen Schicht (104) auf der flexiblen Basis (101)
Bilden der piezoelektrischen Schicht 104) auf dem zweiten Abschnitt (108B) der Passivierungsschicht (108)
aufweist.

11. Verfahren gemäß Anspruch 10, wobei die Passivierungsschicht (108) eine erste Passivierungsschicht (1081) und eine auf der ersten Passivierungsschicht (1081) angeordnete zweite Passivierungsschicht (1082) aufweist,
wobei das Bereitstellen der flexiblen Basis (101) außerdem
Bilden einer Leitung (109) auf dem zweiten Abschnitt (108B) der ersten Passivierungsschicht (1081)
aufweist,
wobei das Bilden des akustische Oberflächenwellen erzeugenden Elements (102) und des akustische Oberflächenwellen erfassenden Elements (103) außerdem:
Bilden eines ersten Durchgangs durch die piezoelektrische Schicht (104) und den zweiten Abschnitt (108B) der zweiten Passivierungsschicht (1082) und Erreichen der Leitung (109) vor dem Bilden der interdigitalen Elektrode (105)
aufweist, und
wobei das Bilden der interdigitalen Elektrode (105)
Bilden einer ersten leitenden Schicht (111) auf der piezoelektrischen Schicht (104) und im ersten Durchgang und
Strukturieren der ersten leitenden Schicht (111) zum Bilden der interdigitalen Elektrode (105)
aufweist,
wobei das Verfahren wahlweise außerdem
Bilden eines zweiten Durchgangs durch den ersten Abschnitt (108A) der Passivierungsschicht (108) und Erreichen eines Source/Drain-Gebiets des Dünnfilmtransistors (107) während des Bildens des ersten Durchgangs aufweist,
wobei die erste leitende Schicht (111) außerdem den zweiten Durchgang ausfüllt,
und das Strukturieren der ersten leitenden Schicht (111) außerdem eine Source/Drain-Elektrode (1071) des Dünnfilmtransistors (107) bildet.

12. Verfahren zum Erkennen einer Biegung im flexiblen Substrat gemäß einem der Ansprüche 1 bis 8 mit
Eingeben (S 11) eines elektrischen Signals in das akustische Oberflächenwellen erzeugende Element (102), um eine akustische Oberflächenwelle zu erzeugen, wobei das Biegen der flexiblen Basis (101) eine Veränderung mindestens eines Merkmals der akustischen Oberflächenwelle bewirkt,
Empfangen (S12) der akustischen Oberflächenwelle durch das akustische Oberflächenwellen erfassende Element (103), um ein elektrisches Ausgangssignal zu erzeugen, wobei sich das elektrische Ausgangssignal auf der Grundlage der Änderung des mindestens einen Merkmals der akustischen Oberflächenwelle ändert, und
Erfassen (S13) der Biegung auf der Grundlage der Änderung des elektrischen Ausgangssignals.

## Revendications

1. Substrat flexible, comprenant :
une base flexible (101) pourvue d'une pluralité de transistors à couches minces (107) agencés en une matrice ;
un élément de génération d'onde acoustique de surface (102) et un élément de détection d'onde acoustique de surface (103) positionné sur la base flexible (101),
l'élément de génération d'onde acoustique de surface (102) et l'élément de détection d'onde acoustique de surface (103) étant configurés pour détecter une courbure du substrat flexible, et
une couche de passivation (108) sur la base flexible (101) et la pluralité de transistors à couches minces (107), la couche de passivation (108) ayant une première partie (108A) positionnée dans une région dans laquelle sont positionnés les transistors à couches minces (107) et une deuxième partie (108B) positionnée dans une région située entre les transistors à couches minces (107) adjacents, l'élément de génération d'onde acoustique de surface (102) et l'élément de détection d'onde acoustique de surface (103) étant positionnés sur la deuxième partie (108B),
l'élément de génération d'onde acoustique de surface (102) et l'élément de détection d'onde acoustique de surface (103) comprenant :
une couche piézoélectrique (104) ; et
une électrode interdigitée (105) positionnée sur la couche piézoélectrique (104), et
la couche piézoélectrique (104) étant disposée sur un côté d'une région de canal des transistors à couches minces (107) éloigné de la base flexible (101) et isolée électriquement de la région de canal des transistors à couches minces (107) par la couche de passivation (108).

2. Substrat flexible selon la revendication 1, dans lequel l'élément de génération d'onde acoustique de surface (102) est configuré pour générer une onde acoustique de surface sur la base d'un signal électrique d'entrée ;
l'élément de détection d'onde acoustique de surface (103) étant configuré pour recevoir l'onde acoustique de surface pour générer un signal électrique de sortie ; et
la flexion de la base flexible (101) provoquant un changement d'au moins une caractéristique de l'onde acoustique de surface, et provoquant un changement du signal électrique de sortie sur la base duquel la flexion est détectée, et, éventuellement, l'au moins une caractéristique comprenant au moins l'un d'une fréquence, d'une phase et d'une amplitude.

3. Substrat flexible selon la revendication 1 ou 2, dans lequel un matériau de la couche piézoélectrique (104) comprend l'un quelconque des matériaux suivants : ZnO, AIN et c-BN.

4. Substrat flexible selon la revendication 3, comprenant en outre un élément réfléchissant (106) positionné sur au moins l'un des emplacements suivants :
un côté de l'élément de génération d'onde acoustique de surface (102) éloigné de l'élément de détection d'onde acoustique de surface (103), et l'élément réfléchissant (106) étant éventuellement positionné sur la couche piézoélectrique (104) ; et
un côté de l'élément de détection d'onde acoustique de surface (103) éloigné de l'élément de génération d'onde acoustique de surface (102), et l'élément réfléchissant (106) étant éventuellement positionné sur la couche piézoélectrique (104).

5. Substrat flexible selon la revendication 3, comprenant en outre un matériau d'absorption acoustique (210) positionné sur au moins l'un des emplacements suivants :
un côté de l'élément de génération d'onde acoustique de surface (102) éloigné de l'élément de détection d'onde acoustique de surface (103), et le matériau d'absorption acoustique (210) étant éventuellement positionné sur la couche piézoélectrique (104) ; et
un côté de l'élément de détection d'onde acoustique de surface (103) éloigné de l'élément de génération d'onde acoustique de surface (102), et le matériau d'absorption acoustique (210) étant éventuellement positionné sur la couche piézoélectrique (104).

6. Substrat flexible selon l'une quelconque des revendications 3 à 5, dans lequel une électrode source/drain (1071) du transistor à couches minces et l'électrode interdigitée (105) sont formées par le même matériau.

7. Substrat flexible selon la revendication 1, dans lequel la couche de passivation (108) comprend une première couche de passivation (1081) et une deuxième couche de passivation (1082) positionnée sur la première couche de passivation (1081), le substrat flexible comprenant en outre un conducteur (109) positionné sur la deuxième partie (108B) de la première couche de passivation (1081), et l'élément de génération d'onde acoustique de surface (102) et l'élément de détection d'onde acoustique de surface (103) étant connectés électriquement au conducteur (109) à travers un via formé dans la deuxième couche de passivation (1082).

8. Substrat flexible selon l'une quelconque des revendications 1 à 7, comprenant en outre une couche de planéification (110) appliquée sur l'élément de génération d'onde acoustique de surface (102) et l'élément de détection d'onde acoustique de surface (103).

9. Dispositif d'affichage OLED flexible comprenant le substrat flexible 100 selon l'une quelconque des revendications 1 à 8, le dispositif d'affichage OLED flexible comprenant éventuellement également :
un circuit d'attaque (501) connecté à l'élément de génération d'onde acoustique de surface (102) et configuré pour commander l'élément de génération d'onde acoustique de surface (102) pour qu'il génère l'onde acoustique de surface ; et
une unité de traitement (502) connectée à l'élément de détection d'onde acoustique de surface (103) et configurée pour traiter le signal électrique de sortie de l'élément de détection d'onde acoustique de surface (103).

10. Procédé de fabrication d'un substrat flexible, comprenant :
la fourniture (S81) d'une base flexible (101) ; et
la formation (S82) d'un élément de génération d'onde acoustique de surface (102) et d'un élément de détection d'onde acoustique de surface (103) sur la base flexible (101), l'élément de génération d'onde acoustique de surface (102) et l'élément de détection d'onde acoustique de surface (103) étant configurés pour détecter une flexion du substrat flexible,
la fourniture (S81) d'une base flexible (101) comprenant :
la formation d'une pluralité de transistors à couches minces (107) disposés en une matrice sur la base flexible (101) ; et
la formation d'une couche de passivation (108) sur la base flexible (101) et la pluralité de transistors à couches minces (107),
la formation (S82) de l'élément de génération d'onde acoustique de surface (102) et de l'élément de détection d'onde acoustique de surface (103) comprenant :
la formation d'une couche piézoélectrique (104) sur la base flexible (101) ; et la formation d'une électrode interdigitée (105) sur la couche piézoélectrique (104),
et la couche piézoélectrique (104) étant formée sur un côté d'une région de canal des transistors à couches minces (107) éloigné de la base flexible (101) et isolée électriquement de la région de canal des transistors à couches minces (107) par la couche de passivation (108),
la couche de passivation (108) ayant une première partie (108A) positionnée dans une région dans laquelle sont positionnés les transistors à couches minces (107) et une deuxième partie (108B) positionnée dans une région située entre les transistors à couches minces (107) adjacents de la base flexible (101), et
la formation de la couche piézoélectrique (104) sur la base flexible (101) comprenant :
la formation de la couche piézoélectrique (104) sur la deuxième partie (108B) de la couche de passivation (108).

11. Procédé selon la revendication 10, dans lequel la couche de passivation (108) comprend une première couche de passivation (1081) et une deuxième couche de passivation (1082) positionnée sur la première couche de passivation (1081),
la fourniture de la base flexible (101) comprenant en outre :
la formation d'un conducteur (109) sur la deuxième partie (108B) de la première couche de passivation (1081),
la formation de l'élément de génération d'onde acoustique de surface (102) et de l'élément de détection d'onde acoustique de surface (103) comprenant en outre :
la formation d'un premier via pénétrant à travers la couche piézoélectrique (104) et la deuxième partie (108B) de la deuxième couche de passivation (1082) et atteignant le conducteur (109), avant la formation de l'électrode interdigitée (105), et
la formation de l'électrode interdigitée (105) comprenant :
la formation d'une première couche conductrice (111) sur la couche piézoélectrique (104) et dans le premier via, et
la structuration de la première couche conductrice (111) pour former l'électrode interdigitée (105),
le procédé comprenant en outre éventuellement :
la formation d'un deuxième via pénétrant à travers la première partie (108A) de la couche de passivation (108) et atteignant une région source/drain du transistor à couches minces (107) tout en formant le premier via, la première couche conductrice (111) remplissant en outre le deuxième via, et la structuration de la première couche conductrice (111) formant en outre une électrode source/drain (1071) du transistor à couches minces (107).

12. Procédé de détection d'une flexion du substrat flexible selon l'une quelconque des revendications 1 à 8, comprenant :
l'introduction (S11) d'un signal électrique dans l'élément de génération d'onde acoustique de surface (102) pour générer une onde acoustique de surface, la flexion de la base flexible (101) provoquant un changement d'au moins une caractéristique de l'onde acoustique de surface ;
la réception (S12) de l'onde acoustique de surface par l'élément de détection d'onde acoustique de surface (103) pour générer un signal électrique de sortie, le signal électrique de sortie changeant sur la base du changement de l'au moins une caractéristique de l'onde acoustique de surface ; et
la détection (S13) de la flexion sur la base du changement du signal électrique de sortie.
